(19) Europäisches Patentamt
European Patent Office
Office européen des brevets

(11) **EP 2 713 318 B1**

(12) **FASCICULE DE BREVET EUROPEEN**

(45) Date de publication et mention
de la délivrance du brevet:
**12.06.2019 Bulletin 2019/24**

(51) Int Cl.:
***G06N 3/063*** *(2006.01)*      ***G06N 3/04*** *(2006.01)*
***G06N 3/08*** *(2006.01)*      ***G11C 11/54*** *(2006.01)*

(21) Numéro de dépôt: **13185999.3**

(22) Date de dépôt: **25.09.2013**

(54) **Système neuromorphique exploitant les caractéristiques intrinseque de cellules de mémoire**

Neuromorphes System, das die intrinsischen Eigenschaften von Speicherzellen nutzt

Neuromorphic system exploiting the intrinsic characteristics of memory cells

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.09.2012 FR 1259050**

(43) Date de publication de la demande:
**02.04.2014 Bulletin 2014/14**

(73) Titulaires:
• **COMMISSARIAT À L'ÉNERGIE ATOMIQUE ET AUX
ÉNERGIES ALTERNATIVES
75015 Paris (FR)**
• **Centre National de la Recherche Scientifique
75016 Paris (FR)**

(72) Inventeurs:
• **Suri, Manan
38000 Grenoble (FR)**
• **Bichler, Olivier
91300 Massy (FR)**
• **De Salvo, Barbara
38330 Montbonnot Saint Martin (FR)**
• **Gamrat, Christian
91940 Les Ulis (FR)**
• **Querlioz, Damien
92330 Sceaux (FR)**

(74) Mandataire: **Priori, Enrico et al
Marks & Clerk France
Immeuble "Visium"
22, avenue Aristide Briand
94117 Arcueil Cedex (FR)**

(56) Documents cités:
**US-A1- 2012 011 093**

• **O. BICHLER, D. QUERLIOZ, S. J. THORPE, J.-P. BOURGOIN, C. GAMRAT: "Extraction of temporally correlated features from dynamic vision sensors with spike-timing-dependent plasticity", NEURAL NETWORKS (SPECIAL ISSUE: SELECTED PAPERS FROM IJCNN'11), vol. 32, 14 février 2012 (2012-02-14), pages 339-348, XP055064709, DOI: 10.1016/j.neunet.2012.02.022**
• **O. Bichler: "Apprentissage neuro-inspiré avec des nano-dispositifs memristifs", Actes des 14è Journées Nationales du Réseau Doctoral en Micro-nanoélectronique (JNRDM'11), 23 mai 2011 (2011-05-23), pages 11-15, XP055064708, Extrait de l'Internet: URL:http://www.cnfm.fr/VersionFrancaise/an imations/JNRDM/articles_JNRDM2011/Concepti on-test/BICHLER Olivier.pdf [extrait le 2012-08-24]**
• **M. Suri, O. Bichler, D. Querlioz, G. Palma, E. Vianello, D. Vuillaume, C. Gamrat, B. DeSalvo: "CBRAM devices as binary synapses for low-power stochastic neuromorphic systems: auditory (cochlea) and visual (retina) cognitive processing applications", Technical program of the 2012 IEEE International Electron Devices Meeting (IEDM'12) to be held 10-12 December 2012, 8 septembre 2012 (2012-09-08), page 22, XP055064706, Extrait de l'Internet: URL:http://wayback.archive.org/web/2012091 6013712/http://www.his.com/~iedm/program/2 012_techprogram.pdf [extrait le 2012-09-16]**

- J-S SEO, B BREZZO, Y LIU, B D PARKER, S K ESSER, R K MONTOYE, B RAJENDRAN, J A TIERNO, L CHANG, D S MODHA, D J FRIEDMAN: "A 45nm CMOS neuromorphic chip with a scalable architecture for learning in networks of spiking neurons", PROCEEDINGS OF THE 2011 IEEE CUSTOM INTEGRATED CIRCUITS CONFERENCE (CICC'11), 19 septembre 2011 (2011-09-19), XP032063741, DOI: 10.1109/CICC.2011.6055293

- M. Di Ventra, Y. V. Pershin: "Biologically-inspired electronics with memory circuit elements", arXiv:1112.4987 [q-bio.NC], 21 décembre 2011 (2011-12-21), XP055064707, Extrait de l'Internet: URL:http://arxiv.org/abs/1112.4987v1 [extrait le 2013-05-29]

**Description**

L'invention concerne un système neuromorphique exploitant les caractéristiques intrinsèque de cellules de mémoire. Elle s'applique au domaine des réseaux de neurones artificiels. Ces réseaux sont schématiquement inspirés des réseaux de neurones biologiques dont ils imitent le fonctionnement.

Les réseaux de neurones artificiels sont composés essentiellement de neurones interconnectés entre eux par des synapses. Les synapses sont habituellement des mémoires numériques ou des composants résistifs dont la conductance varie en fonction de la tension ou du courant appliquée à leurs bornes.

Une règle d'apprentissage classiquement utilisée par les réseaux de neurones impulsionnels est la règle STDP « Spike Timing Dépendent Plasticity ». Il s'agit d'une règle d'inspiration biologique dont l'objectif est de reproduire le fonctionnement de l'apprentissage par les neurones et synapses biologiques. Pour cela, la conductance des synapses doit varier en fonction des instants d'arrivée relatifs des impulsions « pre » et « post » synaptiques transmises par les neurones connectés respectivement en entrée et en sortie. Selon la règle STDP, la conductance d'une synapse est augmentée si son neurone post-synaptique est activé après son neurone pré synaptique et diminuée dans le cas inverse. En outre, la variation de conductance dépend également du délai précis entre les impulsions générées suite à l'activation des neurones. Typiquement plus le délai est important, moins la conductance va varier.

Pour une règle STDP ou toute autre méthode d'apprentissage non supervisé, il est nécessaire que la conductance des composants memristifs qui modélisent les synapses artificielles du réseau puisse varier de façon progressive, en fonction de la tension ou du courant appliquée à leurs bornes, à la fois dans le sens de l'augmentation et de la diminution. En outre, il est désirable que cela puisse se faire sans connaissance préalable de l'état de conductance de la synapse.
Des cellules utilisant la technologie CBRAM « Conductive Bridging Random-Access Memory » sont par exemple utilisées pour les synapses du réseau de neurones. Ces cellules sont habituellement regroupées sous la forme de matrice mémoire.

Une cellule CBRAM possède une électrode en métal actif électrochimiquement comme de l'argent (Ag) ou du cuivre (Cu). Des cations Ag+ de grande mobilité dérivent dans une couche conductrice, par exemple en sulfure de germanium (GeS2), et sont rejetés au niveau d'une anode par exemple en tungstene (W). Cela conduit à la croissance de dendrites Ag, c'est-à-dire à la constitution d'un filament à haute conductivité. Lorsque ce filament existe, le circuit CBRAM est dans un état appelé état ON. La résistance du circuit est alors très faible. Par conséquent, sa conductance G=1/R est très élevée.

Lorsqu'une inversion de polarité de tension est appliquée aux bornes de la cellule CBRAM, une dissolution électrochimique du pont conducteur se produit et le circuit est alors en position OFF. On parle alors de réinitialisation du système. En position OFF, la résistance du circuit est alors élevée. Par conséquent, sa conductance G=1/R est faible.

L'utilisation de cellules CBRAM dans un système neuromorphique présente plusieurs avantages. En effet, la fabrication du système est facilitée et le système est compatible CMOS. Le choix de ce type de cellules est très avantageux pour la conception de systèmes bio-inspirés de faible puissance.

Dans l'art antérieur, la programmation multi-niveaux de cellules CBRAM a été proposée afin d'imiter la plasticité des synapses biologiques. Cependant, cette approche implique que chaque neurone génère des impulsions dont l'amplitude augmente tout en conservant un historique de l'état antérieur des cellules synaptiques, ce qui conduit à une complexité supplémentaire dans le système neuromorphique.

Bichler et al. (Technical program of IEDM'12, page 22, publié le 8 septembre 2012, extrait le 16 septembre 2012 de http:// wayback.archive.org/web/20120916013712/http://www.his.com/~iedm/ program/2012_techprogram.pdf) évoque un circuit neuromorphique, avec des synapses utilisant des CBRAMs dont on peut programmer la probabilité intrinsèque de commutation afin de réaliser un apprentissage non supervisé de type STDP. Néanmoins, il s'agit d'un abrégé ne décrivant pas les détails de l'architecture du circuit neuromorphique.

Bichler (Actes des JNRDM'11, pages 11-15, publié le 23 mai 2011, extrait le 24 août 2012 de http://www.cnfm.fr/VersionFrancaise/animations/JNRDM/ articles_JNRDM2011/Conception-test/BICHLER Olivier.pdf) ainsi que Bichler et al. (Neural Networks, vol. 32, pp. 339-348, 14 février 2012 ; DOI:10.1016/j.neunet.2012.02.022) décrivent un circuit neuromorphique dont les synapses utilisent des composant memristifs. Leur programmation permet également de réaliser un apprentissage de type STDP, mais elle ne repose pas sur la probabilité intrinsèque de commutation des composants memristifs, bien que les composants memristifs suivants puissent être utilisés : PCM, CBRAM, RRAM, MRAM, etc.

Un but de l'invention est notamment de pallier les inconvénients précités.

A cet effet l'invention a pour objet un système neuromorphique, selon la revendication 1, ainsi qu'un procédé de détermination d'impulsions d'écriture et de retour aptes à ajuster les résistances de composants memristifs utilisées dans ledit système neuromorphique, selon la revendication 9, et un programme d'ordinateur dont l'exécution par un ordinateur met en oeuvre ledit procédé, selon la revendication 10. D'autres aspects de l'invention sont définis dans les revendications dépendantes.

D'autres caractéristiques et avantages de l'invention apparaîtront à l'aide de la description qui suit donnée à titre illustratif et non limitatif, faite en regard des dessins annexés parmi lesquels :

- la figure 1 représente un synoptique fonctionnel d'un réseau de neurones artificiel selon l'art antérieur ;
- la figure 2 donne un exemple de système neuromorphique ;
- la figure 3 illustre de fonctionnement d'un système neuromorphique fonctionnant en mode lecture ;
- figure 4 donne un exemple de règle STDP ;
- la figure 5 illustre le fonctionnement d'un système neuromorphique en mode écriture ;
- la figure 6 illustre le principe de combinaisons des impulsions LTP ou LTP avec l'impulsion de retour ;
- la figure 7 illustre la manière dont un générateur de nombre aléatoire peut être utilisé pour une règle d'apprentissage dans un système neuromorphique ;
- la figure 8a donne un exemple de variation de probabilité de commutation Preset en modifiant la tension appliquée à une mémoire CBRAM ;
- la figure 8b donne un exemple de variation de probabilité de commutation Pset en modifiant la tension appliquée à une mémoire CBRAM ;
- la figure 9 donne un exemple d'impulsions de programmation permettant d'obtenir une probabilité intrinsèque cible lorsque des cellules CBRAM basés sur GeS2 et Ag sont utilisées.

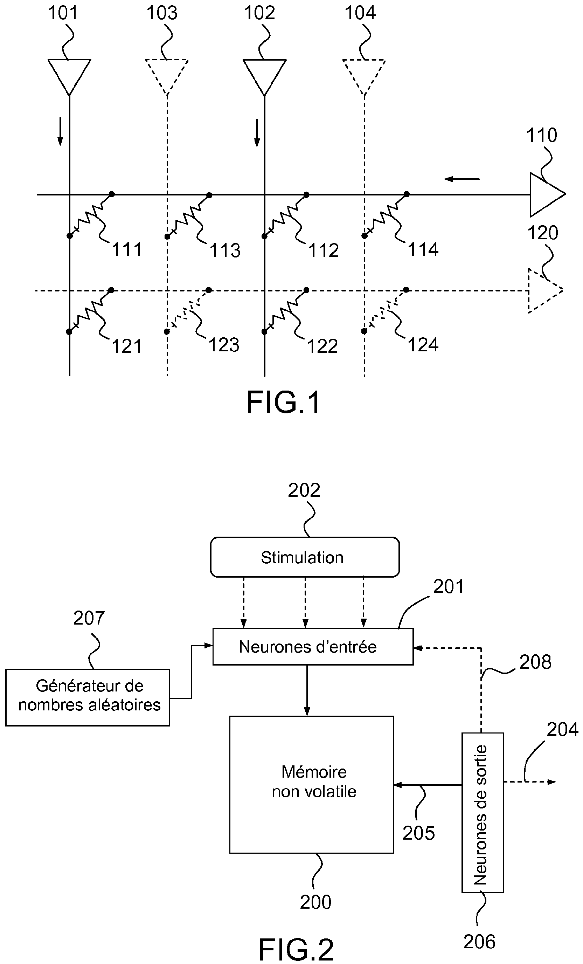

La figure 1 représente un synoptique fonctionnel d'un réseau de neurones artificiel selon l'art antérieur.

Une pluralité de neurones d'entrée 101, 102, 103, 104 sont connectés à une pluralité de neurones de sortie 110, 120 par l'intermédiaire d'une pluralité de synapses artificielles 111, 112, 113, 114, 121, 122, 123, 124. Une synapse artificielle peut être réalisée au moyen d'un composant memristif dont la conductance G varie en fonction du courant ou de la tension appliquée à ses bornes. Une synapse 111 a l'un de ses deux terminaux connecté à un neurone d'entrée 101 et l'autre terminal connecté à un neurone de sortie 110. Un neurone artificiel est un composant actif qui peut présenter simultanément ou séparément les fonctions de neurone d'entrée et/ou de neurone de sortie. Un neurone artificiel est appelé neurone d'entrée lorsqu'il est connecté en aval d'une synapse et neurone de sortie lorsqu'il est connecté en amont d'une synapse. Les neurones artificiels peuvent être actifs ou inactifs. Sur la figure 1, à titre d'exemple, les neurones d'entrée 101, 102 sont considérés actifs et les neurones d'entrée 103, 104 inactifs. De même le neurone de sortie 110 est actif alors que le neurone de sortie 120 est inactif. Un neurone est actif lorsqu'à l'instant considéré, il émet une impulsion. La durée de son état « actif » peut être prédéterminée.

La figure 2 donne un exemple de système neuromorphique.

Un tel système peut être sur un unique circuit dédié, sur un circuit programmable ou en utilisant une combinaison des deux. Ainsi certaines parties peuvent être logicielles et d'autres parties peuvent utiliser des architectures dédiées.

Ce système se compose de quatre blocs principaux. Un premier bloc 200 est une matrice mémoire non volatile ou une mémoire de type « crossbar ».

Dans cette description, la technologie CBRAM est pris en exemple, mais la description est applicable à d'autres types de mémoires résistives à technologies nanométriques comme par exemple les technologies PMC « Programmable Metalization Cell », PCM « Phase Change Memory » ou OXRAM « Oxide Based Memory ». Elle peut en outre être appliquée à des mémoires magnétiques comme les MRAM « Magnetoresistive Random-Access Memory » ou à des mémoires STT-RAM « Spin-Transfer Torque Random Access Memory ».

Dans cette description, les expressions « composant memristif », « cellule mémoire à résistance variable », « cellule de mémoire » sont équivalentes et désignent tout composant non volatile dont la résistance peut être programmée.

Un bloc 201 comprenant des neurones d'entrée est utilisé pour la génération de signaux d'entrée qui seront injectés dans le bloc de mémoire 200. Différents types de modèles de neurones peuvent être utilisés. A titre d'exemple, des neurones de type LIF « Leaky Integrate-and-Fire » peuvent être utilisés.

Les neurones d'entrées peuvent être stimulés par un bloc 202 générant des signaux de stimulation habituellement désignés par le mot anglais « spikes ». Ce bloc émule par exemple l'oreille interne et en particulier la cochlée. D'autres applications pouvant être également considérées. Un autre exemple est d'utiliser une rétine artificielle comme bloc de stimulation 202. De manière plus générale, le bloc 202 peut être une source de tout type de données numériques ou analogiques, asynchrones ou synchrones utilisées comme entrée pour effectuer une reconnaissance de formes, de classification de motifs ou de traitement du signal. Ce modèle peut être fondé sur un modèle biologique.

Un bloc 206 comprenant des neurones de sortie est utilisé pour générer les signaux de sortie 204 du système neuromorphique. Ces neurones génèrent dans certains cas des signaux 205, 208 permettant un apprentissage par la matrice de mémoire comprenant les synapses.

Un générateur de nombres aléatoires 207 peut être utilisé dans une partie du circuit mémoire pour tout type de règle d'apprentissage probabiliste ou stochastique, comme par exemple une règle STDP.

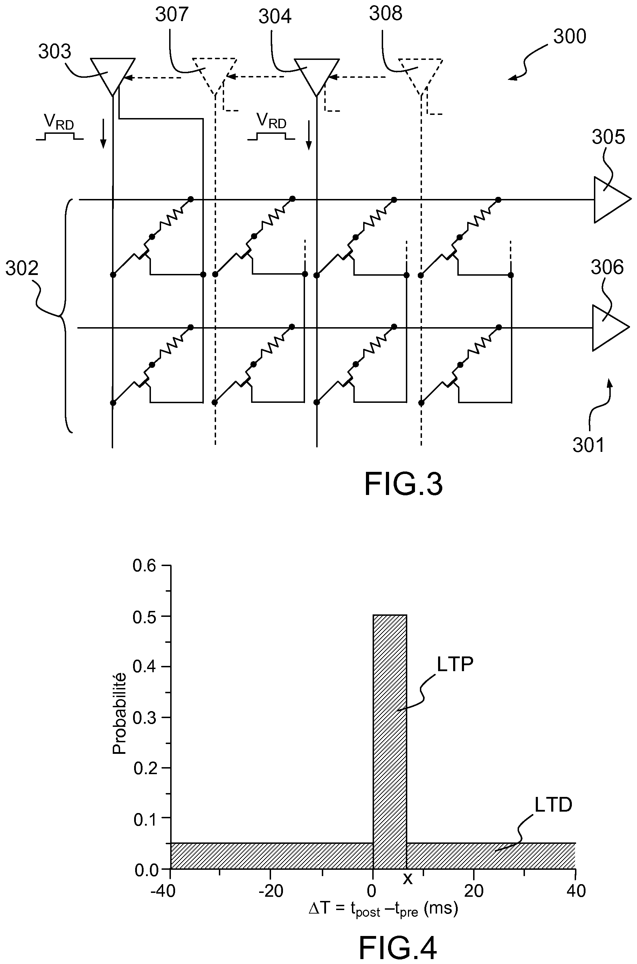

Les figures 3 à 7 donnent un exemple de règle d'apprentissage STDP dans un système neuromorphique comprenant une matrice de mémoire composée de huit cellules CBRAM.

La figure 3 illustre le fonctionnement d'un système neuromorphique fonctionnant en mode lecture. Le mode lecture est un mode durant lequel le poids des synapses ne peut être modifié, à la différence du mode d'écriture.

L'exemple présenté comprend quatre neurones d'entrée 300 et deux neurones de sortie 301. Les synapses sont une matrice comprenant huit cellules CBRAM.

Quand un neurone d'entrée reçoit un événement à partir des données d'entrée, il génère en mode lecture une impulsion de tension faible VRD qui se propage à tous les neurones de sortie par l'intermédiaire des synapses les reliant entre eux.

Dans cet exemple, des signaux d'entrée sont présents au niveau des neurones 303 et 304 et sont actifs. C'est pour cela qu'ils sont représentés en traits pleins. En conséquence, chacun de ces neurones 303, 304 génère un signal de tension VRD. Ces impulsions de lecture se propagent dans la matrice 302 pour atteindre les deux neurones de sortie 305, 306.

Une impulsion de lecture de tension VRD induit au niveau des synapses un courant qui est inversement proportionnel à leur résistance. Par exemple, lorsque les neurones 303, 304 génèrent une impulsion de tension VRD, le courant circulant à travers toutes les lignes synaptiques est additionné ou intégrés par les neurones de sortie 305, 306. Lorsque la somme du courant total à l'intérieur d'un neurone de sortie LIF atteint un certain seuil, elle se déclenche et génère une impulsion électrique. Dans ce cas, le neurone de sortie est actif et représenté en traits pleins. Ce déclenchement du neurone de sortie active le mode écriture.

Le poids des synapses ne peut pas être modifié en mode en lecture, car l'impulsion VRD est définie de telle sorte qu'elle ne perturbe pas l'état de la cellule. Elle est juste suffisante pour lire la résistance du dispositif synaptique. Le poids de la synapse peut être modifiée ou programmé uniquement dans le mode écriture.

La figure 4 donne un exemple de règle STDP. Sur l'axe des ordonnées est représentée la probabilité de commutation vers un état final.

L'axe des abscisses représente l'écart de temps $\Delta T$ exprimé en millisecondes entre une impulsion post-synaptique émise à l'instant $t_{post}$ et une impulsion pre-synaptique émise à l'instant $t_{pre}$ au niveau d'une synapse CBRAM donnée.

Lorsqu'un neurone d'entrée est activée, il entre dans un mode appelé mode LTP. Le neurone d'entrée reste dans ce mode LTP pendant une durée définie par le temps de la fenêtre LTP associée à la règle STDP. A titre d'exemple, un neurone activé peut rester en mode LTP pendant x millisecondes.

La règle d'apprentissage peut être définie finement en tenant compte de l'application visée par le système neuromorphique. La probabilité associée aux fenêtres LTP et LTD peut être affinée en fonction de la précision souhaitée, par exemple dans le cadre d'applications de reconnaissance de formes.

En utilisant des algorithmes évolutionnaires tels que des algorithmes génétiques, des valeurs optimisées de probabilités LTP et LTD peuvent être déterminées. L'algorithme évolutionnaire peut être exécuté sur n'importe quel simulateur de réseau neural d'usage général. A titre d'exemple, le fonctionnement du simulateur Xnet est décrit dans l'article de O. Bichler et al intitulé Extraction of temporally correlated features from dynamic vision sensors with spike-timing-dependent plasticity, 2012 Special Issue, Elsevier, Neural Networks 32 (2012) 339-348.

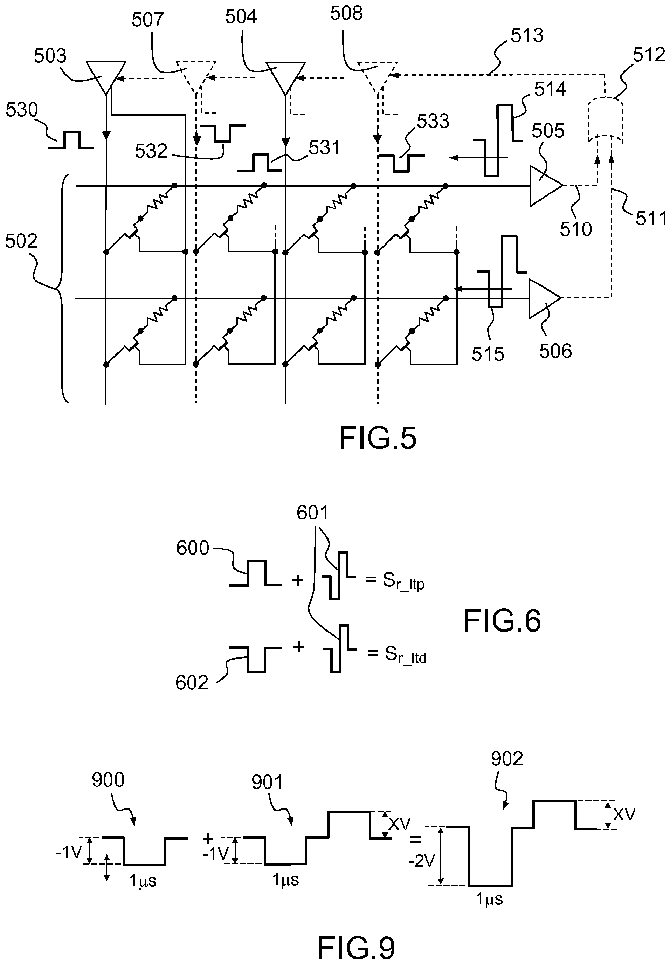

La figure 5 illustre le fonctionnement d'un système neuromorphique en mode écriture.

Le circuit présenté en exemple est identique à celui présenté à l'aide de la figure 3. Il comprend quatre neurones d'entrée 503, 504, 507, 508 et deux neurones de sortie 505, 506. Les synapses sont une matrice 502 comprenant huit cellules CBRAM.

Afin d'expliquer le fonctionnement du système neuromorphique en mode écriture, il est pris comme hypothèse qu'à la fin du mode de lecture, les deux neurones de sortie 505, 506 ont pu atteindre le seuil de déclenchement et qu'ils génèrent en conséquence deux signaux de sortie non représentés.

Lors de son déclenchement et en plus de l'émission d'un signal de sortie, un neurone de sortie effectue deux tâches.

Une première tâche correspond à l'émission d'un signal de commande 510, 511. Ces signaux sont combinés de manière à générer 512 un unique signal de commande 513 à destination des neurones d'entrée de manière à indiquer qu'une opération d'écriture est nécessaire. Par exemple, un signal de commande unifié 513 est généré si au moins un signal de commande présent en entrée d'un module de combinaison 512.

Une seconde tâche consiste à émettre une impulsion de retour 514, 515 qui est renvoyée sur les lignes de connexion synaptiques du neurone de sortie avec les neurones d'entrée.

Une fois que le neurone de sortie est déclenché et que les neurones d'entrée ont reçu le signal de commande 513 indiquant le passage en mode écriture, il existe plusieurs possibilités pour mettre à jour les poids synaptiques en tenant compte de la règle d'apprentissage STDP.

Si le neurone d'entrée a été préalablement activé et qu'il se trouve en mode LTP lorsque le neurone est déclenché, il génère une impulsion d'écriture de type LTP 530, 531 qui conduira à une diminution de la résistance sur les synapses après combinaison avec l'impulsion de retour.

D'autre part, si le neurone d'entrée n'a pas été préalablement activé ou bien que le signal d'écriture de commande 513 a été reçu alors que le neurone d'entrée n'est plus en mode LTP, une impulsion d'écriture de type LTD 532, 533 doit être générée. Dans ce cas, la résistance des synapses peut augmenter après combinaison avec l'impulsion de retour.

La figure 6 illustre le principe de combinaisons des impulsions LTP ou LTP avec l'impulsion de retour.

La forme des impulsions LTP et LTD ainsi que la forme de l'impulsion de retour dépend du type de technologie utilisée dans la matrice de mémoire. Dans cet exemple, la matrice de mémoire utilise par exemple des cellules CBRAM. Ainsi, les formes des impulsions LTP, LTD et de l'impulsion de retour doivent être définies en respectant les principes suivants. Lorsque l'impulsion de retour 601 et l'impulsion LTP 600 interagissent sur une cellule de mémoire, l'impulsion résultante Sr_ltp est positive ce qui a pour effet de diminuer la résistance.

Par ailleurs, lorsque l'impulsion de retour 601 et l'impulsion LTD 602 interagissent sur une cellule de mémoire, l'impulsion résultante Sr_ltd est négative ce qui a pour effet d'augmenter la résistance de la cellule.

L'impulsion de retour 601 est définie de sorte que si elle atteint une cellule mémoire sans interagir avec une impulsion LTD ou LTP, la résistance de ladite cellule ne sera pas modifiée.

Dans un système stochastique l'utilisation d'un générateur de nombre pseudo-aléatoires 207, 320, 520 est une manière d'introduire les probabilités LTP et LTD dans la règle d'apprentissage par exemple de type STDP.

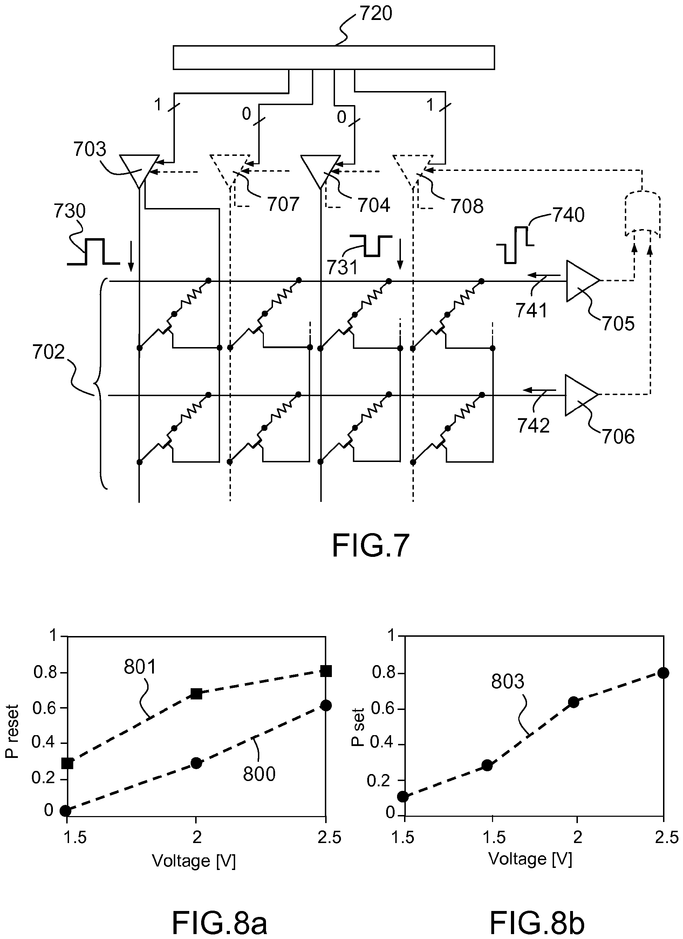

La figure 7 illustre la manière dont un générateur de nombre aléatoire 720 peut être utilisé pour une règle d'apprentissage dans un système neuromorphique. Cette technique est notamment explicitée dans la publication de demande de brevet n° US2012/0011093.

La figure 7 donne un exemple de système neuromorphique comprenant quatre neurones d'entrée 703, 704, 707, 708 et deux neurones de sortie 705, 706. Les synapses sont une matrice 702 comprenant des cellules CBRAM.

Dans un exemple, les sorties du générateur 720 sont connectées aux neurones d'entrée de manière à ce que les nombres aléatoires générés puissent être multipliés avec les signaux générés en sortie des neurones d'entrée 703, 704, 707, 708. Le générateur génère en sortie des « zéro » et des « un » avec des probabilités LTP et LTD définies par la règle STDP dont un exemple a été donné figure 4.

Suivant les principes exposés précédemment, les neurones d'entrée 703, 704 sont en mode LTP et ont donc vocation à émettre une impulsion de type LTP 730. En outre, aucun signal n'est présenté en entrée des neurones 707, 708. Ils ne sont pas en mode LTP et ont donc vocation à émettre une impulsion de type LTD 731.

Dans l'exemple donné, à un instant t et de manière à introduire les probabilités LTD et LTP associées à la règle d'apprentissage STDP choisie, le générateur 720 génère un « un » à destination des neurones 703 et 708 et un « zéro » pour les neurones 704 et 707. Cela a pour effet d'inhiber les neurones 704 et 707 qui n'émettront pas d'impulsions. Le générateur 720 est adapté de manière à éviter l'émission d'impulsions LTD ou LTP autant de fois que nécessaire de manière à ce que la matrice de mémoire soit configurée en suivant la règle d'apprentissage STDP.

Les figures 3 à 7 ont permis de décrire l'apprentissage dans un système neuromorphique en prenant un exemple particulier utilisant un générateur de nombres aléatoires.

Le système neuromorphique réside autrement sur une approche dans laquelle la règle d'apprentissage s'appuie sur une adaptation des caractéristiques des impulsions LTD, LTP et des impulsions de retour aux caractéristiques intrinsèques des cellules mémoire.

Un exemple de caractéristique intrinsèque est la probabilité intrinsèque de commutation des cellules mémoire appelée aussi stochasticité qui est une caractéristique essentielle des dispositifs nanométriques de mémoire résistive, appelés aussi composant memristifs, qui peut être exploitée pour une utilisation dans le type de systèmes neuromorphiques.

En termes simples, la probabilité de commutation P peut être définie en utilisant l'expression suivante :

$$P = Nsuccess/Ntrials$$

dans laquelle :

Nsuccess représente le nombre de commutations réussies ;
Ntrials représente le nombre total d'essais en vue de faire commuter une synapse.

Une commutation est considérée réussie en fonction des spécifications électriques des circuits de mémoire utilisés et en tenant compte des facteurs tels que la dissipation de puissance et la complexité des circuits.

A titre d'exemple, une commutation peut être considérée comme réussie si le rapport de résistance est supérieur à dix, ledit rapport de résistance étant défini en utilisant l'expression suivante :

$$\theta \equiv \frac{R\_off}{R\_on}$$

Dans laquelle :

R_off représente la résistance de la cellule CBRAM dans son état OFF ;
R_on représente la résistance de la cellule CBRAM dans son état ON.

Pour les composants memristifs, comme par exemple les cellules CBRAM basés sur GeS2 et Ag, il apparaît de manière surprenante que la probabilité de commutation d'un premier état de conductance à un second état de conductance peut être contrôlée en changeant les conditions de programmation de la synapse. Dans la suite de la description, l'expression « conditions de programmation » désigne un jeu d'au moins un paramètre caractéristique des impulsions LTD, LTP et/ou de l'impulsion de retour.

Dans un exemple, la probabilité de commutation peut être réglée en choisissant avec soin la bonne combinaison des paramètres suivants :

- la largeur d'impulsion ;
- le temps de montée et de descente de l'impulsion ;
- l'amplitude de l'impulsion.

Deux combinaisons de paramètres distinctes peuvent être choisies pour les impulsions LTD d'une part et pour les impulsions LTP d'autre part.

La figure 8a donne un exemple de variation de probabilité de commutation Preset de l'état ON vers l'état OFF pour une cellule CBRAM basés sur GeS2 et Ag.

Pour passer dans un autre état, il est habituel d'utiliser une impulsion dont l'amplitude correspond à la tension en ligne appelée également en utilisant l'expression anglo-saxonne «Bit-line Voltage ».

Dans cet exemple, le rapport de résistance $\theta$ est supérieur à dix. Deux courbes 800, 801 sont représentées. L'axe des ordonnées correspond à la probabilité de commutation Preset vers de l'état ON vers l'état OFF. L'axe des abscisses correspond à la tension en ligne Vg exprimé en volts.

La première courbe 800 correspond à une largeur d'impulsion égale à cinq cents nanosecondes et la seconde courbe 801 correspond à une largeur d'impulsion égale à une microseconde. Dans cet exemple, les temps de montée et le temps de descente sont choisis identiques pour les deux courbes. La première courbe 800 indique qu'avec une tension appliquée aux bornes de la cellule CBRAM égale à deux volts, une probabilité de commutation égale à 0,3 est atteinte. Pour ce qui est de la seconde courbe 801, il apparaît que pour cette même valeur de tension, une probabilité de commutation égale à 0,7 est atteinte. Cela montre bien qu'en choisissant les paramètres des impulsions utilisés, la probabilité de commutation de l'élément résistif jouant le rôle de synapse peut-être ajustée finement. Ces paramètres peuvent être déterminés en utilisant par exemple des courbes obtenues par mesure.

La figure 8b donne un exemple de variation de probabilité de commutation Pset de l'état OFF vers l'état ON pour une mémoire CBRAM basés sur GeS2 et Ag.

Pour passer dans l'état bas en utilisant ce type de mémoire, il est habituel d'utiliser une impulsion dont l'amplitude correspond à la tension d'anode. L'axe des ordonnées correspond à la probabilité de commutation de l'état OFF vers l'état ON. L'axe des abscisses correspond à la tension en ligne exprimée en volts. Une courbe 803 est donnée en exemple et montre qu'avec une amplitude égale à deux volts, une probabilité de commutation égale à 0,63 est atteinte.

La figure 9 donne un exemple d'impulsions de programmation permettant d'obtenir une probabilité de commutation cible lorsque des cellules CBRAM basés sur GeS2 et Ag sont utilisées.

Dans cet exemple, le passage de l'état ON à l'état OFF des cellules CBRAM est visé avec une probabilité de 0,7 correspondant à la règle d'apprentissage sélectionnée. Il faut pour cela générer une impulsion LTD. En se basant sur la figure 8a, l'impulsion résultant de la combinaison de l'impulsion LTD et de l'impulsion de retour doit avoir une amplitude égale à deux Volts et une largeur d'une microseconde.

XV signifie que cette partie de l'impulsion peut être choisie sur la base d'autres critères que les caractéristiques intrinsèques des cellules mémoire. Les temps de montée et de descente de chaque impulsion peuvent être par exemple choisis égaux à deux cents nanosecondes.

Afin de déterminer les conditions de programmation, plusieurs alternatives peuvent être envisagées.

Une première approche consiste à utiliser un modèle prédictif du comportement des composants memristifs utilisées. L'utilisation de ce modèle peut être empirique, phénoménologique, compacte, comportementale ou physique. Des simulations peuvent également être utilisées. L'objectif est d'obtenir un jeu de paramètres pour générer des impulsions permettant d'atteindre une probabilité de commutation donnée, et cela quelque soit la technologie choisie pour les synapses.

Dans une approche alternative, les conditions de programmation de la technologie synaptique sont déterminées au niveau « Wafer-Level », c'est-à-dire avant le conditionnement du système neuromorphique. Cette caractérisation peut être effectuée automatiquement ou manuellement, par exemple à l'aide d'une sonde. Des tests paramétriques peuvent également être utilisés.

Dans une troisième approche, les conditions de programmation peuvent être déterminées par des mesures directes effectuées sur le système neuromorphique. Avantageusement, cette méthode permet de suivre en temps réel les évolutions des caractéristiques de commutation sur un système neuromorphique après conditionnement et intégration. Ces données en temps réel permettent alors d'adapter les conditions de programmation dans le système afin d'obtenir de meilleurs résultats.

Une fois les conditions de programmation déterminées, le système neuromorphique peut alors être programmé.

Les conditions de programmation sont mémorisées dans le système neuromorphique de manière à ce que les neurones d'entrées et de sortie puissent émettre les impulsions adaptées aux caractéristiques intrinsèques des cellules mémoire et à la règle d'apprentissage choisie pour le système neuromorphique.

L'utilisation des conditions de programmations adaptées aux caractéristiques intrinsèques des cellules mémoire a pour avantage déterminant de permettre au système neuromorphique une consommation réduite d'énergie. En outre, l'architecture du système est simplifiée, le seul besoin étant de mémoriser les impulsions adaptées à la règle d'apprentissage.

Dans un autre exemple, le système neuromorphique peut être programmé à la fois en utilisant les conditions de programmation adaptées aux caractéristiques intrinsèques des cellules mémoire, mais également en utilisant en combinaison un générateur de nombres aléatoires comme explicité précédemment. Ainsi, si plusieurs matrices de mémoire sont utilisées dans le système, une partie de ces matrices peut être configurée en utilisant les conditions de programmation adaptées aux caractéristiques intrinsèques des cellules mémoire et le reste des matrices peut être configuré en utilisant le générateur aléatoire. Cet exemple a l'avantage de permettre une flexibilité de programmation du système. En effet, si certaines valeurs de probabilité ne sont pas atteignables en utilisant les conditions de programmation adaptées aux caractéristiques intrinsèques de certaines cellules mémoire, la technique se basant sur l'utilisation d'un générateur de nombres aléatoires peut être avantageusement utilisée.

## Revendications

1. Système neuromorphique comprenant un ensemble d'au moins un neurone dit d'entrée (503, 504, 507, 508), un ensemble d'au moins un neurone dit de sortie (505, 506) et un réseau synaptique (502) mis en oeuvre par un ensemble d'au moins un composant memristif, chaque dit composant memristif reliant un neurone d'entrée (503, 504, 507, 508) à un neurone de sortie (505, 506), ledit ou chaque dit neurone d'entrée étant configuré pour générer des impulsions dites d'écriture de type LTD (602) et LTP (600), et ledit ou chaque dit neurone de sortie étant configuré pour générer des impulsions dites de retour, ledit ou au moins un dit composant memristif étant adapté pour que la valeur de sa résistance soit ajustée par l'envoi dans le réseau synaptique de dites impulsions d'écriture (530, 531, 532, 533) générées par ledit ou au moins un dit neurone d'entrée et de dites impulsions de retour (514, 515) générées par ledit ou au moins un dit neurone de sortie, lesdits neurones d'entrée et de sortie étant configurés, en fonction d'une probabilité intrinsèque de commutation dudit ou d'un dit composant memristif, de telle sorte que la combinaison, au niveau dudit ou d'au moins un dit composant memristif, d'une dite impulsion d'écriture (530, 531, 532, 533), générée par ledit ou un dit neurone d'entrée, avec une dite impulsion de retour (514, 515), générée par ledit ou un dit neurone de sortie, résulte en une modification de la résistance dudit composant mémristif suivant une règle d'apprentissage non supervisé préalablement choisie.

2. Système selon la revendication précédente dans lequel la règle d'apprentissage est une règle d'inspiration biologique de type STDP.

3. Système selon l'une des revendications précédentes dans lequel ladite règle d'apprentissage non supervisé est une règle d'apprentissage ayant été optimisée par un algorithme évolutionnaire.

4. Système selon l'une des revendications précédentes dans lequel la règle d'apprentissage définit une probabilité de commutation d'un composant memristif d'un premier état vers un second état, ledit second état étant **caractérisé par** une valeur de résistance inférieure à celle dudit premier état, ladite probabilité étant définie par le rapport entre un nombre de commutation considérées réussie et un nombre d'essais de commutation, une commutation étant considérée réussie lorsque le rapport entre la valeur de résistance du composant memristif dans le premier état et la valeur de résistance du composant memristif dans un second état est supérieure à une valeur prédéfinie.

5. Système selon l'une des revendications précédentes dans lequel lesdits neurones d'entrée et de sortie sont configurés de telle sorte que lesdites impulsions d'écriture et de retour présentent :

   - des largeurs d'impulsion ;
   - des temps de montée et de descente; et
   - des amplitudes de l'impulsion

   déterminées en fonction de ladite probabilité intrinsèque de commutation dudit ou d'un dit composant memristif, de telle sorte que la combinaison d'une dite impulsion d'écriture (530, 531, 532, 533) avec une dite impulsion de retour (514, 515) au niveau dudit ou d'au moins un dit composant memristif résulte en une modification de sa résistance suivant ladite règle d'apprentissage préalablement choisie.

6. Système selon l'une des revendications précédentes comprenant également un générateur de nombres aléatoires et un deuxième réseau synaptique mis en oeuvre par un deuxième ensemble d'au moins un composant memristif, chaque dit composant memristif reliant un neurone d'entrée à un neurone de sortie, dans lequel le générateur de nombres aléatoires est configuré pour bloquer ou autoriser l'émission des impulsions d'écriture par le au moins un dit neurone d'entrée connecté au deuxième réseau synaptique, de manière à ce que le deuxième ensemble d'au moins un composant memristif soit configuré selon la règle d'apprentissage non supervisée.

7. Système selon l'une des revendications précédentes dans lequel les composants memristifs sont des cellules CBRAM.

8. Système selon la revendication 1 dans lequel les composants memristifs sont de technologie PMC, PCM, OXRAM, MRAM ou STTRAM.

9. Procédé de détermination d'impulsions d'écriture (900) et d'impulsions de retour (901) aptes à ajuster les résistances de composants memristifs utilisées dans un système neuromorphique selon l'une quelconque des revendications précédentes, ledit procédé comprenant les étapes suivantes :

- détermination de la probabilité de commutation des composants memristifs dudit système d'un premier état vers un second état en fonction de paramètres des impulsions lui étant appliquées ;
- sélection d'un jeu dedits paramètres permettant d'obtenir une probabilité de commutation associée à une règle d'apprentissage STDP prédéfinie ;
- détermination d'une impulsion d'écriture (900) et d'une impulsion de retour (901) dont la combinaison permet d'obtenir une impulsion (902) respectant le jeu de paramètre identifié à l'étape précédente.

10. Programme d'ordinateur stocké sur un support lisible par ordinateur comprenant des instructions telles que leur exécution par ledit ordinateur conduit à la mise en oeuvre d'un procédé détermination d'impulsions d'écriture et d'impulsions de retour selon la revendication 9.

**Patentansprüche**

1. Neuromorphes System, welches Folgendes beinhaltet: eine Gruppe von mindestens einem Neuron, genannt Eingangsneuron (503, 504, 507, 508), eine Gruppe von mindestens einem Neuron, genannt Ausgangsneuron (505, 506) und ein synaptisches Netzwerk (502), welches durch eine Gruppe von mindestens einem memristiven Bauelement umgesetzt wird, wobei jedes memristive Bauelement ein Eingangsneuron (503, 504, 507, 508) mit einem Ausgangsneuron (505, 506) verbindet, wobei das oder ein jedes Eingangsneuron konfiguriert ist, um Schreibimpulse genannte Impulse vom Typ LTD (602) und LTP (600) zu erzeugen, und wobei das oder jedes Ausgangsneuron konfiguriert ist, um Rückmeldeimpulse genannte Impulse zu erzeugen, wobei das oder mindestens ein memristives Bauelement dazu geeignet ist, dass sein Widerstandwert durch die Sendung der Schreibimpulse (530, 531, 532, 533) in das synaptische Netzwerk, welche durch das oder mindestens ein Eingangsneuron erzeugt werden, und der Rückmeldeimpulse (514, 515), welche durch das oder mindestens ein Ausgangsneuron erzeugt werden, angepasst wird, wobei die Eingangs- und die Ausgangsneuronen solchermaßen konfiguriert sind, entsprechend einer intrinsischen Umschaltwahrscheinlichkeit des oder mindestens eines memristiven Bauelements, dass die Kombination, auf Höhe des oder des mindestens einen memristiven Bauelements, eines Schreibimpulses (530, 531, 532, 533), welcher durch das oder ein Eingangsneuron erzeugt wird, mit einem Rückmeldeimpuls (514, 515), welcher durch das oder ein Ausgangsneuron erzeugt wird, eine Änderung des Widerstandes des memristiven Bauelements nach einer nicht überwachten, zuvor gewählten Lernregel bewirkt.

2. System nach dem vorhergehenden Anspruch, bei welchem die Lernregel eine der Biologie nachempfundene Regel vom Typ STDP ist.

3. System nach einem der vorhergehenden Ansprüche, bei welchem die nicht überwachte Lernregel eine Lernregel ist, welche durch einen evolutionären Algorithmus optimiert wurde.

4. System nach einem der vorhergehenden Ansprüche, bei welchem die Lernregel eine Umschaltwahrscheinlichkeit eines memristiven Bauelements von einem ersten Zustand in einen zweiten Zustand definiert, wobei der zweite Zustand durch einen geringeren Widerstandswert als derjenige des ersten Zustandes definiert wird, wobei die Wahrscheinlichkeit durch das Verhältnis zwischen einer Anzahl von als erfolgreich betrachteten Umschaltungen und einer Anzahl von Umschaltversuchen definiert wird, wobei eine Umschaltung als erfolgreich betrachtet wird, wenn das Verhältnis zwischen dem Widerstandswert des memristiven Bauelementes im ersten Zustand und dem Widerstandswert des memristiven Bauelementes in einem zweiten Zustand einen vorbestimmten Wert überschreitet.

5. System nach einem der vorhergehenden Ansprüche, bei welchem die Eingangs- und die Ausgangsneuronen so konfiguriert sind, dass die Schreib- und Rückmeldeimpulse Folgendes aufweisen:

- Impulsbreiten;
- Anstiegs- und Abstiegszeiten; und
- Impulsamplituden,

welche angesichts der intrinsischen Umschaltwahrscheinlichkeit des oder eines memristiven Bauelementes bestimmt werden, so dass die Kombination eines Schreibimpulses (530, 531, 532, 533) mit einem Rückmeldeimpuls (514, 515) auf Höhe des oder mindestens eines memristiven Bauelementes eine Änderung seines Widerstandes entsprechend der zuvor gewählten Lernregel bewirkt.

**6.** System nach einem der vorhergehenden Ansprüche, welches ebenfalls einen Zufalls-Zahlengenerator und ein zweites synaptisches Netzwerk beinhaltet, welches durch eine zweite Gruppe von mindestens einem memristiven Bauelement umgesetzt wird, wobei ein jedes memristives Bauelement ein Eingangsneuron mit einem Ausgangsneuron verbindet, wobei der Zufalls-Zahlengenerator konfiguriert ist, um die Aussendung der Schreibimpulse durch das mindestens eine Eingangsneuron zu blockieren oder zu autorisieren, welches mit dem zweiten synaptischen Netzwerk verbunden ist, so dass die zweite Gruppe von mindestens einem memristiven Bauelement entsprechend der nicht überwachten Lernregel konfiguriert wird.

**7.** System nach einem der vorhergehenden Ansprüche, bei welchem die memristiven Bauelemente CBRAM-Zellen sind.

**8.** System nach Anspruch 1, bei welchem die memristiven Bauelemente Elemente mit PMC-, PCM-, OXRAM-, MRAM- oder STTRAM-Technologie sind.

**9.** Verfahren zur Bestimmung von Schreibimpulsen (900) und von Rückmeldeimpulsen (901), welche in der Lage sind, die Widerstände von in einem neuromorphen System nach einem der vorhergehenden Ansprüche verwendeten memristiven Bauelementen anzupassen, wobei das Verfahren folgende Schritte beinhaltet:

- Bestimmen der Umschaltwahrscheinlichkeit der memristiven Bauelemente des Systems von einem ersten Zustand in einen zweiten Zustand anhand von Parametern der hierauf angewandten Impulse;
- Auswählen eines Satzes Parameter, welcher es ermöglicht, eine mit einer vorbestimmten STDP-Lernregel assoziierte Umschaltwahrscheinlichkeit zu erzielen;
- Bestimmen eines Schreibimpulses (900) und eines Rückmeldeimpulses (901), deren Kombination es ermöglicht, einen Impuls (902) zu erzielen, welcher den im vorhergehenden Schritt identifizierten Parametersatz beachtet.

**10.** Computerprogramm, welches auf einem computerlesbaren Träger gespeichert ist und derartige Anweisungen enthält, dass deren Ausführung durch den Computer die Umsetzung eines Verfahrens zur Bestimmung von Schreibimpulsen und von Rückmeldeimpulsen nach Anspruch 9 ermöglicht.

## Claims

**1.** Neuromorphic system comprising a set of at least one input neuron (503, 504, 507, 508), a set of at least one output neuron (505, 506) and a synaptic network (502) formed from a set of at least one memristive component, each said memristive component connecting an input neuron (503, 504, 507, 508) to an output neuron (505, 506), said or each input neuron being configured to generate write pulses of type LTD (602) and LTP (600), and said or each output neuron being configured to generate return pulses, said or at least one said memristive component being adapted so that its resistance value is adjusted by sending said write pulses (530, 531, 532, 533) in the synaptic network, generated by said or at least one said input neuron, and said return pulses (514, 515) generated by said or at least one said output neuron, said input and output neurons being configured, depending on an intrinsic switching probability of said or a said memristive component, so that the combination, at said or at least one said memristive component, of a write pulse (530, 531, 532, 533) generated by said or a said input neuron with a said return pulse (514, 515) generated by said or a said output neuron results in a modification of the resistance of the memristive component according to a non-supervised learning rule chosen beforehand.

**2.** System according to the preceding claim, wherein the learning rule is a biologically inspired rule of the STDP type.

**3.** System according to one of the preceding claims, wherein said non supervised learning rule is a learning rule that has been optimized with an evolutionary algorithm.

**4.** System according to one of the preceding claims, wherein the learning rule defines a switching probability of a memristive component from a first state to a second state, said second state being **characterised by** a lower resistance value than that of the first state, said probability being defined by the ratio between a number of switchings considered to have taken place and a number of switching attempts, switching being considered to have taken place when the ratio between the resistance value of the memristive component in the first state and the resistance value of the memristive component in a second state is greater than a pre-set value.

**5.** System according to one of the preceding claims, wherein said input and output neurons are configured so that the write and return pulses show the following:

- pulse widths;
- rise and fall times; and
- amplitudes of the pulse

determined depending on said intrinsic switching probability of said or a said memristive component, so that the combination of a said write pulse (530, 531, 532, 533) with a said return pulse (514, 515) at said or at least one said memristive component results in a modification of its resistance according to said learning rule chosen beforehand.

6. System according to one of the preceding claims, further comprising a random number generator and a second synaptic network formed by a second set of at least one memristive component, each said memristive component connecting an input neuron to an output neuron, wherein the random number generator is configured to allow the emission of write pulses by the at least one input neuron connected to the second synaptic network to be blocked or authorized, so that the second set of at least one memristive component is configured according to the non-supervised learning rule.

7. System according to one of the preceding claims, wherein the memristive components are CBRAM cells.

8. System according to claim 1, wherein the memristive components are produced in PMC, PCM, OXRAM, MRAM or STTRAM technology.

9. Method for determining write pulses (900) and return pulses (901) able to adjust the resistances of memristive components used in a neuromorphic system according to any one of the preceding claims, said method comprising the following steps:

   - determining the switching probability of the memristive components of the system from a first state to a second state depending on the parameters of the pulses applied to it;
   - selecting a set of said parameters allowing a switching probability associated with a pre-set STDP learning rule to be obtained;
   - determining a write pulse (900) and a return pulse (901) the combination of which allows a pulse (902) respecting the parameter set identified in the preceding step to be obtained.

10. Computer program stored on a computer-readable medium, comprising instructions that are such that their execution by said computer results in the implementation of a method for determining write pulses and return pulses according to claim 9.

FIG.1

FIG.2

FIG.3

FIG.4

FIG.5

FIG.6

FIG.9

FIG.7

FIG.8a

FIG.8b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120011093 A

**Littérature non-brevet citée dans la description**

- **BICHLER et al.** *Technical program of IEDM'12,* 08 Septembre 2012, 22, http:// wayback.archive.org/web/20120916013712/http://www.his.com/~iedm/ program/2012_techprogram.pdf
- **BICHLER.** *Actes des JNRDM'11,* 23 Mai 2011, 11-15, http://www.cnfm.fr/VersionFrancaise/animations/JNRDM/ articles_JNRDM2011/Conception-test/BICHLER Olivier.pdf
- **BICHLER et al.** *Neural Networks,* 14 Février 2012, vol. 32, 339-348
- intitulé Extraction of temporally correlated features from dynamic vision sensors with spike-timing-dependent plasticity. **O. BICHLER et al.** Special Issue. Elsevier, 2012, vol. 32, 339-348